# EUROPÄISCHE PATENTSCHRIFT

(11) **EP 2 893 785 B1**
(45) Veröffentlichungstag und Bekanntmachung des Hinweises auf die Patenterteilung: **19.09.2018**
(21) Anmeldenummer: 13745097.9
(22) Anmeldetag: 05.08.2013
(51) Int. Cl.: H05K 5/00, H05K 5/02, H05K 7/14, F16H 61/00, H05K 7/20

(54) **ANORDNUNG EINES ELEKTRISCHEN STEUERGERÄTS AN EINE SCHALTPLATTE**
ARRANGEMENT OF AN ELECTRIC CONTROL DEVICE ON A CIRCUIT BOARD
AGENCEMENT D'UN DISPOSITIF DE COMMANDE ÉLECTRIQUE SUR UNE PLATINE DE CONNEXION

(30) Priorität: 04.09.2012 DE 102012215673
(43) Veröffentlichungstag der Anmeldung: 15.07.2015
(73) Patentinhaber: ZF Friedrichshafen AG, 88046 Friedrichshafen (DE)
(72) Erfinder: LOIBL, Josef, 93077 Bad Abbach (DE)
(86) Internationale Anmeldenummer: PCT/EP2013/066352
(87) Internationale Veröffentlichungsnummer: WO 2014/037173

(56) Entgegenhaltungen:
- EP-A2- 2 273 859
- WO-A1-2008/006637
- DE-U1- 20 115 922
- US-A1- 2006 075 848
- US-A1- 2011 228 478

## Beschreibung

Die Erfindung betrifft ein Baukastensystem für ein Getriebeelement und ein mit dem Getriebeelement verbundenes elektrisches Steuergerät gemäß den Merkmalen im Oberbegriff des geltenden Patentanspruchs 1.

Getriebesteuerungen für Fahrzeuggetriebe umfassen eine zentrale elektronische Steuereinheit, mit der weitere Steuerungsbaugruppen, wie beispielsweise Sensoren, Ventile, ein Stecker für einen Anschluss an andere Fahrzeugsysteme und dergleichen, verbindbar sind. Häufig wird die fertig gehauste elektronische Steuereinheit an einem Getriebeelement, wie beispielsweise einer Schaltplatte befestigt.

Die DE 10 2007 061 116 A1 bezieht sich auf ein Steuergerätegehäuse, insbesondere für ein Getriebesteuerungsmodul eines Getriebes eines Kraftfahrzeugs. Das Steuergerätegehäuse umfasst ein erstes Gehäuseteil und ein zweites, deckelförmiges Gehäuseteil.

Die nicht vorveröffentlichte Anmeldung DE 10 2011 007 300.0 beschreibt ein Steuergerät, welches mit einer Leiterplatte eine in einem Getriebeelement vorgesehene Vertiefung abdeckt. In diese Vertiefung ragen z.B. an der Leiterplatte angeordnete elektronische Bauelemente. Zur Wärmeabfuhr der von den elektronischen Bauelementen erzeugten Wärme sind Wärmeleitelemente vorhanden, welche den Zwischenraum zwischen der Bodenfläche der Vertiefung in dem Getriebeelement und der an der Leiterplatte angeordneten elektronischen Bauelementen ausfüllt. Bei diesen Wärmeleitelementen handelt es sich üblicherweise um eine Wärmeleitpaste, was eine nicht lösbare Verbindung zwischen Getriebeelement und Steuergerät bewirkt.

WO 2008/006637 A1 offenbart eine elektronische Ansteuervorrichtung für ein Getriebe umfassend eine Hydraulikplatte, eine elektronische Trägerkomponente und einen Kühlkörper. Die Hydraulikplatte weist eine Ausnehmung auf, in die die Trägerkomponente angeordnet ist. Diese Anordnung führt dazu, dass die Hydraulikplatte als Gehäusedeckel für die zu schützende Leiterplatte mit den elektronischen Trägerkomponenten dient.

US 2011/0228478 A1 beschreibt eine Kühlanordnung für ein Getriebesteuergerät.

US 2006/0075848 A1 beschreibt eine Anordnung eines Getriebes mit einer an dem Getriebegehäuse angebrachten Ölwanne.

EP 2 273 859 A2 beschreibt eine Anordnung eines an einer Hydraulikplatte befestigten Steuergeräts. Das Steuergerät umfasst eine Leiterplatte, deren Ober- und Unterseite zumindest teilweise von einem Gehäuse umgeben ist.

DE 201 15 922 U1 beschreibt eine Kunststoff-Schaltplatte eines hydraulischen Kraftfahrzeug-Getriebesteuergerätes, wobei die Schaltplatte eine Vertiefung aufweist, in welche ein Wärmeleitungskörper integriert ist, auf welchen eine Leiterplatte befestigt ist.

Aufgrund der Forderung nach einer kompakten Bauweise mit einer geringen Bauhöhe sowie einer guten Wärmeabfuhr ist es Aufgabe der Erfindung eine Anordnung anzugeben, bei welcher die Nachteile des Standes der Technik beseitigt werden.

Diese Aufgabe wird durch das Baukastensystem gemäß den Merkmalen des geltenden Patentanspruchs 1 gelöst. Vorteilhafte Ausführungen der Erfindung sind Gegenstand von Unteransprüchen.

Die vorliegende Erfindung schafft eine Anordnung, in Form eines Baukastensystems für ein Getriebeelement und ein mit dem Getriebeelement verbundenes elektrisches Steuergerät, wobei das elektrische Steuergerät eine mit elektronischen Bauelementen bestückte Leiterplatte und ein die Leiterplatte zumindest teilweise umgebendes Gehäuse umfasst, dadurch gekennzeichnet, dass das Getriebeelement eine hydraulische Schaltplatte oder ein Getriebegehäuse ist und eine Vertiefung aufweist, deren flächenmäßige Ausdehnung mindestens der senkrechten Projektion des Gehäuses auf eine Oberfläche des Getriebeelements entspricht, wobei die Höhe der Vertiefung so gewählt ist, dass die Leiterplatte auf der Oberfläche des Getriebeelements abgestützt ist, wobei zumindest ein Teil des Gehäuses des elektrischen Steuergeräts in die Vertiefung eingreift und direkt auf einer Grundfläche des Getriebeelements aufliegt und dass das Getriebeelement weitere Vertiefungen zur Aufnahme von aus dem Gehäuse herausragenden Bereichen der Leiterplatte aufweist, wobei die Höhe der weiteren Vertiefung der Dicke der Leiterplatte entspricht..

Das elektrische Steuergerät ist zweckmäßig ein elektrisches Steuergerät für ein Getriebe eines Fahrzeugs. Bei dem Fahrzeug kann es sich um ein Kraftfahrzeug, wie beispielsweise einen Personenkraftwagen oder Lastkraftwagen, mit einem Schalt- oder Automatikgetriebe handeln. Das Steuergerät kann hierbei eine zentrale steuernde Funktion bei der Getriebesteuerung übernehmen. Das Gehäuse des Steuergerätes kann hierbei eine Wärmeableitfunktion und/oder einen mechanischen Schutz für die Leiterplatte realisieren. Bei der Leiterplatte kann es sich um eine Schaltungsplatine handeln, wie sie auf dem entsprechenden Gebiet bekannt ist. Die Leiterplatte kann mehrlagig ausgeführt sein. Die elektronischen Komponenten des Steuergeräts sind an der Leiterplatte angeordnet. Dazu sind die elektronischen Bauelemente in einem Bauelementebereich der Leiterplatte angeordnet. Bei den elektrischen Bauelementen kann es sich um Schaltelemente, Logikelemente und weitere geeignete elektrische bzw. elektronische Bauteile handeln. Elektrische Anschlüsse der elektrischen Bauelemente sind mit auf oder innerhalb der Leiterplatte ausgeführten Leiterbahnen elektrisch leitfähig verbunden. Zumindest einige der Leiterbahnen der Leiterplatte sind mit den elektrischen Kontakten verbunden, die in einem Kontaktierungsbereich der Leiterplatte angeordnet sind. Bei den Leiterbahnen kann es sich um Verbindungsleitungen aus einem elektrisch leitfähigen Material, wie beispielsweise Kupfer handeln. Die Leiterbahnen können an der Leiterplatte aufgedruckt oder aus der Leiterplatte heraus geätzt sein. Die Leiterbahnen können in einer Schicht oder Lage einer mehrlagigen Leiterplatte gebildet sein. Auf diese Weise können die elektrischen Bauelemente über die außerhalb des Gehäuses angeordneten Kontakte kontaktiert werden. Bei den elektrischen Kontakten kann es sich um geeignete Verbindungselemente zur Verbindung von weiteren Getriebesteuerungselementen mit dem Steuergerät handeln. Dabei können die elektrischen Kontakte beispielsweise als Anschlussflächen, Steckkontakte, Anschlussbuchsen oder dergleichen ausgeführt sein. Verbindungen mit den elektrischen Kontakten können als eine nichtlösbare stoffschlüssige Verbindung oder als eine wiederlösbare kraftschlüssige oder formschlüssige Verbindung ausgeführt werden. Die weiteren Getriebesteuerungselemente können hierbei Sensoren und Ventile sein, die üblicherweise bei einer Getriebesteuerung eingesetzt werden. Bei dem Anschließen der weiteren Getriebesteuerungselemente kann neben einer elektrisch leitfähigen Verbindung auch eine mechanische Verbindung zwischen dem Steuergerät und den weiteren Getriebesteuerungselementen oder Verbindungskabeln zu den weiteren Getriebesteuerungselementen hergestellt werden. Das Gehäuse des Steuergeräts ist dabei so ausgeformt, dass es einen Zugriff auf die elektrischen Kontakte in dem Kontaktierungsbereich der Leiterplatte zum Anschließen der weiteren Getriebesteuerungselemente ermöglicht. Bei dem Getriebeelement kann es sich beispielsweise um eine hydraulische Schaltplatte oder ein Getriebegehäuse handeln. Dabei kann eine Befestigung beispielsweise an einer Oberfläche der innerhalb des Getriebegehäuses angeordneten hydraulischen Schaltplatte oder an einer Innenoberfläche des Getriebegehäuses erfolgen.

Durch die Erfindung wird ferner eine Gewichtseinsparung erzielt.

Das Gehäuse umschließt die Leiterplatte und die darauf angeordneten elektronischen Bauelemente im Bereich der Oberseite und der Unterseite. Zur Ausleitungen von Leiterbahnen an den Kontaktierungsbereich sind im Gehäuse Durchbrechungen vorgesehen. Der Kontaktierungsbereich der Leiterplatte befindet sich außerhalb des Gehäuses.

Das Getriebeelement weist erfindungsgemäß weitere Aussparungen zur Aufnahme von aus dem Gehäuse herausragenden Bereichen der Leiterplatte auf. Bei diesen Bereichen kann es sich um den Kontaktierungsbereich der Leiterplatte handeln oder um weitere Aussparungen, welche der Befestigung des Steuergerätes an dem Getriebeelement dienen. Damit kann die Bauweise weiter komprimiert werden.

In einer weiteren Ausführungsform der Erfindung sind Befestigungsmittel vorhanden zur Herstellung einer lösbaren Verbindung zwischen dem elektrischen Steuergerät und dem Getriebeelement.

Die Erfindung wird anhand der beigefügten Zeichnungen beispielhaft näher erläutert. Es zeigen:
- Fig. 1: eine schematische Darstellung eines Steuergeräts gemäß dem Stand der Technik,
- Fig. 2: eine schematische Schnittdarstellung eines Steuergeräts gemäß dem Stand der Technik,
- Fig. 3: eine schematische Schnittansicht eines Steuergeräts gemäß einem Ausführungsbeispiel der vorliegenden Erfindung,
- Fig. 4: eine schematische Schnittansicht eines Steuergeräts gemäß einem weiteren Ausführungsbeispiel der vorliegenden Erfindung

In der nachfolgenden Beschreibung bevorzugter Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

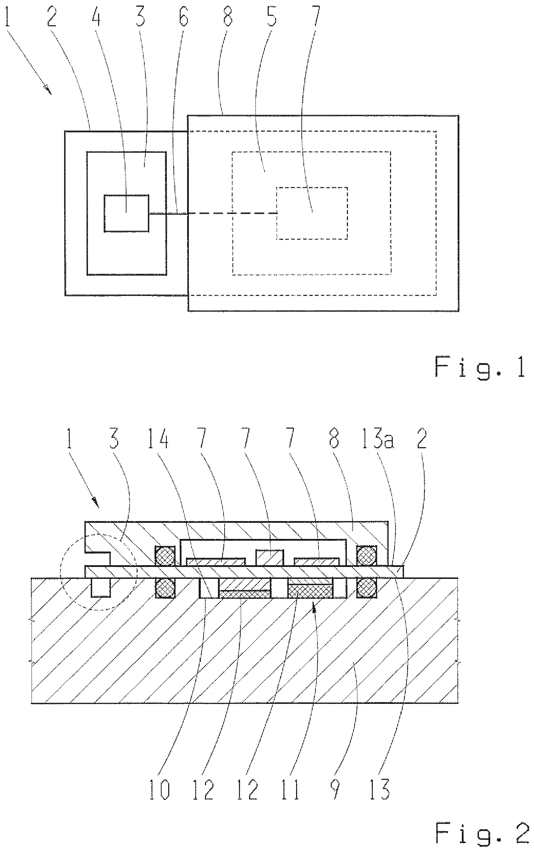

Fig. 1 zeigt eine schematische Darstellung eines Steuergeräts 1 gemäß einem Ausführungsbeispiel der vorliegenden Erfindung. Gezeigt ist ein Steuergerät 1, das eine Leiterplatte 2 mit einem Kontaktierungsbereich 3, in dem lediglich beispielhaft nur ein elektrischer Kontakt 4 angeordnet ist, sowie einem Bauelementbereich 5, in dem lediglich beispielhaft nur ein über eine Leiterbahn 6 mit dem elektrischen Kontakt 4 verbundenes elektrisches Bauelement 7 angeordnet ist.

Ferner ist in der Fig. 1 ein Gehäuse 8 (Abdeckungselement) gezeigt. Auch wenn in Fig. 1 beispielhaft lediglich ein elektrischer Kontakt 4 in dem Kontaktierungsbereich 3 dargestellt ist, können in der Praxis eine Mehrzahl von elektrischen Kontakten 4 vorgesehen sein. Diese Möglichkeit ist in Fig. 1 aus Platzgründen in der Darstellung nicht wiedergegeben. Auch können, obwohl in Fig. 1 beispielhaft lediglich ein elektrisches Bauelement 7 in dem Bauelementbereich 5 dargestellt ist, in der Praxis eine Mehrzahl von elektrischen Bauelementen 7 vorgesehen sein. Diese Möglichkeit ist in Fig. 1 ebenfalls aus Platzgründen in der Darstellung nicht realisiert. Ebenso ist demzufolge in Fig. 1 lediglich beispielhaft nur eine Leiterbahn 6 gezeigt, obwohl in der Praxis eine Mehrzahl von Leiterbahnen 6 vorgesehen sein kann, abhängig von der Anzahl der elektrischen Kontakte 4 und/oder der elektrischen Bauelemente 7.

Die Leiterplatte 2 ist teilweise durch das Abdeckungselement 8 abgedeckt. In Fig. 1 stellen durchgezogene Linien jene Abschnitte der Leiterplatte 2 dar, die nicht durch das Abdeckungselement 8 abgedeckt sind. Bei der Leiterplatte 2 kann es sich um eine Schaltungsplatine oder dergleichen aus einem geeigneten Material handeln. Der Kontaktierungsbereich 3 der Leiterplatte 2 ist nicht durch das Abdeckungselement 8 abgedeckt. Der Kontaktierungsbereich 3 der Leiterplatte 2 ist außerhalb des Abdeckungselements 8 angeordnet. Der Kontaktierungsbereich 4 der Leiterplatte 2 weist eine Mehrzahl elektrischer Kontakte 4 auf, auch wenn in Fig. 1 lediglich ein solcher elektrischer Kontakt 4 dargestellt ist. In dem Kontaktierungsbereich 3 der Leiterplatte 2 können die elektrischen Kontakte 4 zu einer gemeinsamen Kontakteinrichtung zusammengefasst sein oder eine Mehrzahl von Kontakteinrichtungen 3 bilden. Der Bauelementbereich 5 der Leiterplatte 2 ist durch das Abdeckungselement 8 abgedeckt. Der Bauelementbereich 5 der Leiterplatte 2 ist innerhalb des Gehäuses angeordnet und kann auf der Ober- und Unterseite 13a, 13 der Leiterplatte 2 ausgeführt sein. Auch wenn es in Fig. 1 nicht dargestellt ist, so kann der Bauelementbereich 5 eine Mehrzahl elektrischer Bauelemente 7 aufweisen, bei denen es sich um elektronische Bauelemente wie Schaltelemente, Logikelemente oder dergleichen handeln kann. Die Leiterplatte 2 weist zwischen dem Kontaktierungsbereich 3 und dem Bauelementbereich 5 eine Mehrzahl von Leiterbahnen 6 auf, von denen in Fig. 1 lediglich eine beispielhaft gezeigt ist, und welche die elektrischen Kontakte 4 und die elektrischen Bauelemente 7 miteinander verbinden.

Das Gehäuse 8 formt zusammen mit der Leiterplatte 2 einen abgeschlossenen Innenraum aus, in dem die elektrischen Bauelemente 7 angeordnet sind. Der Innenraum kann fluiddicht gegenüber einem Umfeld des Steuergeräts 1 abgedichtet sein.

Fig. 2 zeigt eine schematische Schnittansicht eines Steuergeräts 1 gemäß Fig. 1. Gezeigt ist ein Steuergerät 1, das eine Leiterplatte 2, einen Kontaktierungsbereich 4, elektrische Bauelemente 7 und ein Gehäuseteil 8 aufweist. Das Steuergerät 1 ist an einem Getriebeelement 9 angebracht. Das Steuergerät 1 ist in einem Teilbereich einer Oberfläche des Getriebeelements 9 befestigt. Bei dem Getriebeelement 9 kann es sich um ein Getriebegehäuse oder eine hydraulische Schaltplatte bzw. Steuerung handeln, wie es einem Fachmann auf dem Gebiet elektronisch gesteuerter Getriebe bekannt ist. Das Getriebeelement 9 weist Wärmeleitelemente 12 bzw. Wärmeleitmittel auf.

Das Getriebeelement 9 weist einen Befestigungsbereich 11 auf, in dem das Steuergerät 1 an dem Getriebeelement 9 befestigt ist. Die Abmessungen des Befestigungsbereichs 11 können hierbei Abmessungen des Steuergeräts 1 entsprechen. Das Getriebeelement 9 weist in dem Befestigungsbereich 11 eine Bauelementvertiefung 10 auf. Die Bauelementvertiefung 10 ist so dimensioniert, dass die elektrischen Bauelemente 7 an der dem Getriebeelement 9 zugewandten Hauptoberfläche 13 der Leiterplatte 2 in der Bauelementvertiefung 10 aufnehmbar sind. Ferner sind in der Bauelementvertiefung 10 in dem Befestigungsbereich 11 des Getriebeelements 9 Wärmeleitmittel 12 angeordnet. Die Wärmeleitelemente 12 sind zwischen einer Bodenoberfläche 14 der Bauelementvertiefung 10 und den elektrischen Bauelementen 7 an der dem Getriebeelement 9 zugewandten Hauptoberfläche 13 der Leiterplatte 2 angeordnet. Die Wärmeleitelemente 12 füllen einen Zwischenraum zwischen der Bodenoberfläche 14 der Bauelementvertiefung 10 und den elektrischen Bauelementen 7 an der dem Getriebeelement 9 zugewandten Hauptoberfläche 13 der Leiterplatte 2 aus.

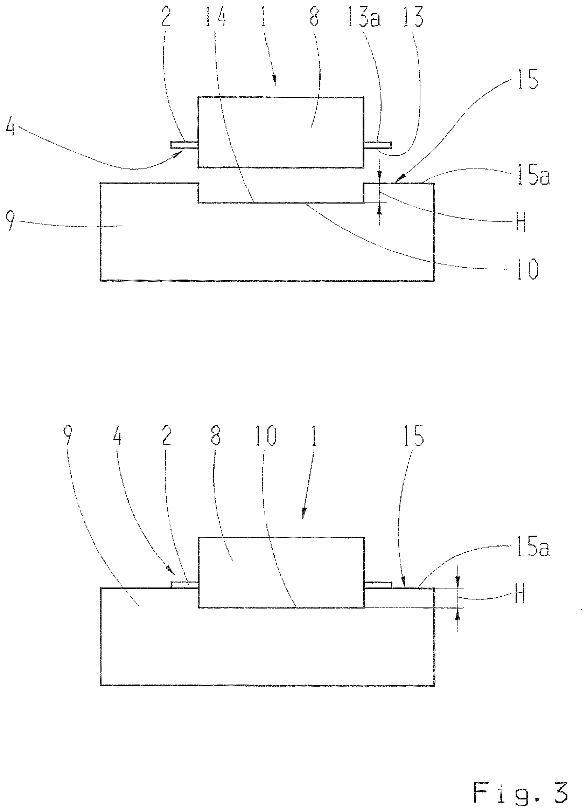

Fig. 3 zeigt eine schematische Schnittansicht eines Steuergeräts 1 gemäß einem Ausführungsbeispiel der vorliegenden Erfindung. Gezeigt ist ein Steuergerät 1 mit einem Gehäuse 8, welches eine Leiterplatte 2 vollständig umschließt. Die Leiterplatte 8 ragt im Bereich der Anschlusskontakte 4 aus dem Gehäuse 2 heraus.

Das Getriebeelement 9 weist eine Vertiefung 10 auf (obere Darstellung), deren flächenmäßige Ausdehnung mindestens der senkrechten Projektion des Gehäuses 8 auf die Oberfläche 15 des Getriebeelements 9 entspricht. Die Höhe H der Vertiefung 10 ist so gewählt, dass die Leiterplatte 2 auf der Oberfläche 15 des Getriebeelements 9 abgestützt ist, d.h. die Unterseite 13 der Leiterplatte 2 und die Oberseite 15a des Getriebeelements 9 liegen direkt aufeinander (untere Darstellung).

Der Teil des Gehäuses 8, der in die Vertiefung 10 eingebracht ist, liegt direkt auf der Bodenoberfläche (14) des Getriebeelements 9 auf. Dadurch wird ein guter Kontakt zwischen dem Gehäuse 8 und dem Getriebeelement 9 gewähreistet, so dass eine gute Wärmeabfuhr möglich ist.

Nicht dargestellt sind die Befestigungsmittel, mittels welcher das Gehäuse 8 des Steuergerätes 1 mit dem Getriebeelement 9 verbunden ist. Hier sind verschiedene Befestigungsmöglichkeiten denkbar. Neben Schraub- und Klemmverbindungen ist auch eine Passverbindung denkbar, sofern sie geeignet ist, eine lösbare Verbindung zwischen dem Steuergerät und der Getriebeeinheit herzustellen.

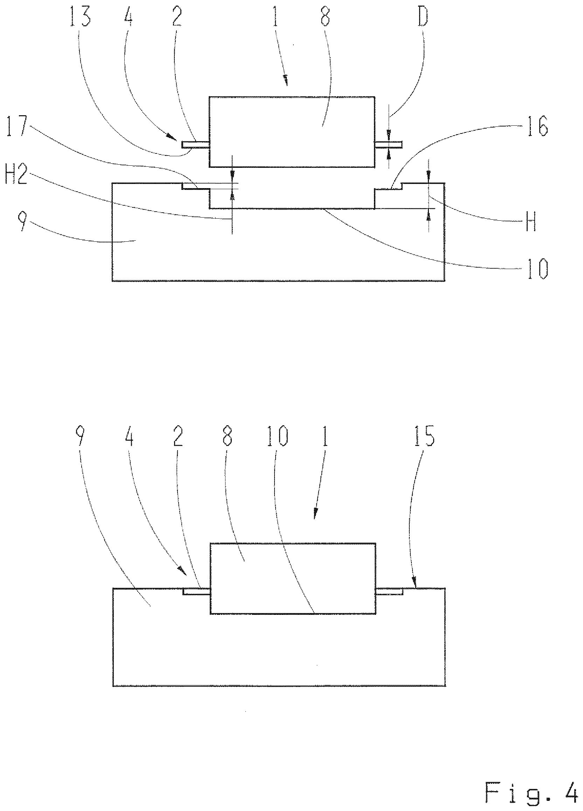

Fig. 4 zeigt eine weitere schematische Schnittansicht eines Steuergeräts 1 gemäß einem Ausführungsbeispiel der vorliegenden Erfindung. Gezeigt ist, entsprechend Fig. 3, ein Steuergerät 1 mit einem Gehäuse 8, welches eine Leiterplatte 2 vollständig umschließt. Die Leiterplatte 2 ragt im Bereich der Anschlusskontakte 4 aus dem Gehäuse 8 heraus.

Wie in Fig. 3 bereits beschrieben weist das Getriebeelement 9 eine Vertiefung 10 auf (obere Darstellung), deren flächenmäßige Ausdehnung mindestens der senkrechten Projektion des Gehäuses 8 auf die Oberfläche 15 des Getriebeelements 9 entspricht. Zusätzlich weist in Fig. 4 das Getriebeelement 9 eine weitere

Vertiefung 16 auf, welche eine flächenmäßige Ausdehnung aufweist, die der senkrechten Projektion des sich außerhalb des Gehäuses 8 befindlichen Bereichs (z.B. des Bereichs der Anschlusskontakte 4) der Leiterplatte 2 entspricht. Der Höhe H2 der weiteren Vertiefung 16 entspricht zweckmäßig die Dicke D der Leiterplatte 2. Die Höhe H der Vertiefung 10 ist so gewählt, dass die Leiterplatte 2 auf der Oberfläche 17 des Getriebeelements 9 abgestützt ist, d.h. die Unterseite 13 der Leiterplatte 2 und die Oberseite 17 des Getriebeelements 9 im Bereich der weiteren Vertiefung 16 liegen direkt aufeinander (untere Darstellung).

## Patentansprüche

1. Baukastensystem für ein Getriebeelement (9) und ein mit dem Getriebeelement (9) verbundenes elektrisches Steuergerät (1), wobei das elektrische Steuergerät (1) eine mit elektronischen Bauelementen (7) bestückte Leiterplatte (2) und ein die Leiterplatte (2) zumindest teilweise umgebendes Gehäuse (8) umfasst, wobei das Getriebeelement (9) eine hydraulische Schaltplatte oder ein Getriebegehäuse ist und eine Vertiefung (10) aufweist, deren flächenmäßige Ausdehnung mindestens der senkrechten Projektion des Gehäuses (8) auf eine Oberfläche (15) des Getriebeelements (9) entspricht, wobei die Höhe (H) der Vertiefung (10) so gewählt ist, dass die Leiterplatte (2) auf der Oberfläche (15) des Getriebeelements (9) abgestützt ist, wobei zumindest ein Teil des Gehäuses (8) des elektrischen Steuergeräts (1) in die Vertiefung (10) eingreift und direkt auf einer Bodenoberfläche (14) des Getriebeelements (9) aufliegt, **dadurch gekennzeichnet, dass** das Getriebeelement (9) weitere Vertiefungen (16) zur Aufnahme von aus dem Gehäuse (8) herausragenden Bereichen (4) der Leiterplatte (2) aufweist, wobei die Höhe (H2) der weiteren Vertiefung (16) der Dicke (D) der Leiterplatte (2) entspricht.

2. Baukastensystem nach Anspruch 1, **dadurch gekennzeichnet, dass** Befestigungsmittel vorhanden sind zur Herstellung einer lösbaren Verbindung zwischen dem elektrischen Steuergerät (1) und dem Getriebeelement (9).

## Claims

1. Modular system for a transmission element (9) and an electrical controller (1) which is connected to the transmission element (9), wherein the electrical controller (1) comprises a printed circuit board (2), which is fitted with electronic components (7), and a housing (8) which at least partially surrounds the printed circuit board (2), wherein the transmission element (9) is a hydraulic shift plate or a transmission housing and has a recess (10), the areal extent of the said recess corresponding at least to the vertical projection of the housing (8) onto a surface (15) of the transmission element (9), wherein the height (H) of the recess (10) is selected such that the printed circuit board (2) is supported on the surface (15) of the transmission element (9), wherein at least a portion of the housing (8) of the electrical controller (1) engages in the recess (10) and rests directly on a bottom surface (14) of the transmission element (9), **characterized in that** the transmission element (9) has further recesses (16) for receiving regions (4) of the printed circuit board (2), the said regions projecting out of the housing (8), wherein the height (H2) of the further recess (16) corresponds to the thickness (D) of the printed circuit board (2).

2. Modular system according to Claim 1, **characterized in that** fastening means are provided for establishing a releasable connection between the electrical controller (1) and the transmission element (9).

## Revendications

1. Système modulaire destiné à un élément de transmission (9) et un appareil de commande électrique (1) relié à l'élément de transmission (9), dans lequel l'appareil de commande électrique (1) comprend une carte de circuit imprimé (2) équipée de composants électroniques (7) et un boîtier (8) entourant au moins partiellement la carte de circuit imprimé (2), dans lequel l'élément de transmission (9) est une carte de circuit hydraulique ou un carter de transmission et présente un évidement (10), dont l'étendue de surface correspond au moins à la projection verticale du boîtier (8) sur une surface (15) de l'élément de transmission (9), dans lequel la hauteur (H) de l'évidement (10) est choisie de telle manière que la carte de circuit imprimé (2) soit supportée sur la surface (15) de l'élément de transmission (9), dans lequel au moins une partie du boîtier (8) de l'appareil de commande électrique (1) s'engage dans l'évidement (10) et repose directement sur une surface de fond (14) de l'élément de transmission (9),
**caractérisé en ce que** l'élément de transmission (9) comporte d'autres évidements (16) destinés à recevoir des régions (4) de la carte de circuit imprimé (2) dépassant du boîtier (8), dans lequel la hauteur (H2) de l'autre évidement (16) correspond à l'épaisseur (D) de la carte de circuit imprimé (2).

2. Système modulaire selon la revendication 1,
**caractérisé en ce que** des moyens de fixation sont prévus pour établir une liaison amovible entre l'appareil de commande électrique (1) et l'élément de transmission (9).
